# EUROPEAN PATENT APPLICATION

(11) **EP 4 439 665 A1**
(43) Date of publication of application: **02.10.2024**
(21) Application number: 22912057.1
(22) Date of filing: 26.12.2022
(51) Int. Cl.: H01L 25/075, H01L 33/56, H01L 33/58, H01L 27/15, H01L 33/48

(54) **LIGHT-EMITTING MODULE AND DISPLAY DEVICE COMPRISING SAME**

(30) Priority: 26.12.2021 US 202163293814 P; 26.12.2021 US 202163293815 P; 23.12.2022 US 202218088316
(71) Applicant: Seoul Viosys Co., Ltd., Ansan-si, Gyeonggi-do 15429 (KR)
(72) Inventor: PARK, Jae Hyun, Ansan-Si Gyeonggi-do 15429 (KR); HONG, Seung Sik, Ansan-Si Gyeonggi-do 15429 (KR)
(74) Representative: Isarpatent
(86) International application number: PCT/KR2022/021283
(87) International publication number: WO 2023/121424

(57) **Abstract**

A light-emitting module according to one embodiment of the present disclosure comprises a circuit board, a plurality of unit pixels arranged on the circuit board, a molding unit for covering the plurality of unit pixels, and an anti-glare layer arranged on the molding unit, wherein the molding unit includes a molding unit containing a dispersing-agent.

## Description

### [Technical Field]

The present disclosure relates to a light emitting module, a method of manufacturing the light emitting module, and a display apparatus including the light emitting module, and more particularly, to a light emitting module including a molding member surrounding a plurality of unit pixels and a display apparatus having the same.

### [Background Art]

Light emitting diodes are semiconductor devices using a light emitting diode which is an inorganic light source and are used in various fields such as display apparatuses, vehicle lamps, and general lightings. As the light emitting diodes have advantages such as long lifespan, low power consumption, and quick response, the light emitting diodes have been replacing conventional light sources.

Conventional light emitting diodes have been generally used as backlight light sources in display apparatuses. Recently, display apparatuses that directly realize images using the light emitting diodes have been developed. Such displays are also referred to as micro LED displays.

The display apparatus generally implements various colors using a mixed color of blue, green, and red. The display apparatus includes a plurality of pixels to implement various images, and each pixel has blue, green, and red sub pixels. As such, a color of a certain pixel is typically determined based on the colors of the sub pixels, so that images can be displayed through the combination of such pixels.

In a case of the micro LED display, micro LEDs are arranged on a plane corresponding to each sub pixel, and a large number of micro LEDs are mounted on a single substrate. However, since the micro LED is extremely small, for example, 200 µm or less, further 100 µm or less, it is difficult to transfer entire micro LEDs to one circuit board. Accordingly, a technique of forming a plurality of light emitting modules and mounting the plurality of light emitting modules on a display substrate, or a technique of mounting the light emitting modules on a plurality of cabinets and then mounting the plurality of cabinets on the display substrate has been used. Each of the light emitting modules has a structure in which the micro LEDs are transferred to a relatively small circuit board.

However, when a display is implemented using the plurality of light emitting modules, a region having different brightness may occur within one light emitting module, or a brightness difference may occur between light emitting modules. Accordingly, the regions having different brightnesses are formed on a display screen, and regions having different image qualities such as brightness and color are formed in a displayed image. Particularly, in a turned-off state, some regions of the display screen are darker or brighter than other regions.

### [Disclosure]

### [Technical Problem]

Exemplary embodiments provide a technology configured to reduce a brightness difference in a light emitting module.

Exemplary embodiments provide a technology configured to reduce a brightness difference between adjacent light emitting modules.

Exemplary embodiments provide a light emitting module configured to prevent a difference in image quality depending on a display screen region and a display apparatus having the same.

### [Technical Solution]

A light emitting module according to an embodiment of the present disclosure includes a circuit board; a plurality of unit pixels arranged on the circuit board; a molding member covering the plurality of unit pixels; and an anti-glare layer disposed on the molding member, in which the molding member includes a diffuser containing molding member.

Thicknesses of the diffuser containing molding member measured at four corners of the circuit board may be within a range of ±10% of an average value thereof.

The diffuser may include silica.

In an embodiment, the molding member may include a first molding member covering the unit pixels and a second molding member disposed on the first molding member, in which the first molding member may be a diffuser containing molding member, and the second molding member may be a black molding member.

Thicknesses of the first molding member measured at the four corners of the circuit board may be within a range of ±10% of an average value thereof.

In another embodiment, the molding member may include a first molding member having a height lower than those of the unit pixels and a second molding member covering the first molding member and the unit pixels, in which the first molding member may be a diffuser containing molding member.

The light emitting module may further include a side seal covering side surfaces of the circuit board and the molding member.

The side seal may be formed of a material different from that of the molding member.

In an embodiment, an upper surface profile of the molding member may be substantially same as an upper surface profile of the circuit board.

In an embodiment, the molding member may include a first molding member and a second molding member covering the first molding member, in which the first molding member is a diffuser-free molding member, and has a flat upper surface, and the second molding member is a diffuser containing molding member.

Furthermore, thicknesses of the second molding member measured at four corners of the circuit board may be within a range of ±10% of an average value thereof.

The anti-glare layer may include an anti-glare film, in which the anti-glare film may include a base; an anti-glare hard coating layer coated on the base; a low reflection coating layer coated on the anti-glare hard coating layer; and an adhesive disposed under the base.

Furthermore, at least one of the base and the adhesive may include a black dye.

In addition, the adhesive may be a pressure sensitive adhesive.

A display apparatus according to an embodiment of the present disclosure includes: a plurality of light emitting modules, each including a circuit board, a plurality of unit pixels arranged on the circuit board, and a first molding member covering the unit pixels; a second molding member covering the plurality of light emitting modules; and an anti-glare layer covering the second molding member, in which the first molding member and the second molding member include a diffuser containing molding member.

Thicknesses of the diffuser containing molding member of the first molding member measured at four corners of the circuit board of each of the light emitting modules may be within a range of ±10% of an average value thereof.

Adjacent light emitting modules may be spaced apart with a gap G, a distance W2 between unit pixels in one light emitting module may be smaller than or equal to a distance W1 between unit pixels between adjacent light emitting modules, and a width W3 of the gap G between the light emitting modules may be smaller than the distance W2 between unit pixels in one light emitting module.

The second molding member may be partially disposed within the gap G between the light emitting modules.

Each of the light emitting modules may include a side seal covering side surfaces thereof, and the light emitting modules may be arranged such that the side seals are in close contact with one another.

The anti-glare layer may include an anti-glare film or anti-glare glass.

A light emitting module according to an embodiment of the present disclosure includes a circuit board; an unit pixel arranged on the circuit board; and a molding member covering the unit pixel, in which thicknesses of the molding member measured at four corners of the circuit board may be within a range of ±10% of an average value thereof.

The molding member may comprise a diffuser.

The light emitting module may further comprise an anti-glare layer disposed on the molding member.

Thicknesses of the molding member measured at four corners of the circuit board may be within a range of ±5% of an average value thereof.

A thickness of the molding member located on top of the unit pixel may be 5 times or less than a height of the unit pixel.

An adhesive may be disposed between the molding member and the anti-glare layer, and a thickness of the adhesive may be smaller than that of the anti-glare layer.

A light emitting module according to an embodiment of the present disclosure includes a circuit board; a unit pixel disposed on the circuit board; and a molding member disposed on the unit pixel, in which the molding member covers at least a portion of a side surface of the circuit board.

The light emitting module may further include an anti-glare layer and an adhesive layer disposed between the molding member and the anti-glare layer.

The molding member may incorporate an anti-glaring agent.

Thicknesses of the molding member measured at four corners of the circuit board may be within a range of ±10% of an average value thereof.

The thickness of the molding member may be 1.2 times or more than that of the unit pixel.

The molding member may partially cover an upper area of the side surfaces of the circuit board.

The molding member may at least partially cover at least one of four corner areas of the circuit board.

A light emitting module according to an embodiment of the present disclosure includes a circuit board; a plurality of unit pixels disposed on the circuit board; a molding member covering the plurality of unit pixels; and a side seal disposed on a side of the circuit board, wherein a width of the side seal is less than or equal to the pitch of adjacent unit pixels.

The width of the side seal may be less than or equal to 1/2 of the pitch.

The side seal may be formed of the same material as the molding member.

The molding member may include a diffuser.

The light emitting module may further include an anti-glare layer.

Thicknesses of the molding member measured at four corners of the circuit board may be within ±10% of an average value thereof.

### [Description of Drawings]

FIG. 1A is a schematic plan view illustrating a display apparatus according to an exemplary embodiment.
FIG. 1B is a schematic perspective view illustrating various display apparatuses according to an exemplary embodiment.
FIG. 1C is a schematic perspective view illustrating another display apparatuses according to an exemplary embodiment.
FIG. 1D is a schematic perspective view illustrating another display apparatuses according to an exemplary embodiment.
FIG. 2A is a schematic plan view illustrating a unit pixel according to an exemplary embodiment.
FIG. 2B is a schematic plan view illustrating a unit pixel according to another exemplary embodiment.
FIG. 2C is a schematic cross-sectional view illustrating a unit pixel according to another exemplary embodiment.
FIG. 2D is a schematic cross-sectional view illustrating a unit pixel according to another embodiment.
FIG. 3A is a schematic cross-sectional view illustrating a light emitting module according to another embodiment of the present disclosure.
FIG. 3B is a schematic plan view illustrating a light emitting module according to another embodiment of the present disclosure.
FIG. 3C is a schematic cross-sectional view illustrating a light emitting module according to another embodiment of the present disclosure.
FIG. 3D is a schematic cross-sectional view illustrating a light emitting module according to another embodiment of the present disclosure.
FIG. 4 is a schematic cross-sectional view illustrating an anti-glare film according to an embodiment of the present disclosure.
FIG. 5 is a schematic flowchart illustrating a method of manufacturing a light emitting module according to an embodiment of the present disclosure.
FIGs. 6A through 6E are schematic cross-sectional views illustrating a method of manufacturing a light emitting module according to an embodiment of the present disclosure.
FIG. 7 is a schematic plan view illustrating a method of forming a molding member according to an embodiment of the present disclosure.
FIG. 8A is a schematic perspective view illustrating a method of manufacturing a molding member according to an embodiment of the present disclosure.
FIG. 8B is a schematic cross-sectional view illustrating a method of manufacturing a molding member according to an embodiment of the present disclosure.
FIG. 9 is a schematic cross-sectional view illustrating a method of manufacturing a molding member according to another embodiment of the present disclosure.
FIG. 10A and FIG. 10B are schematic cross-sectional views illustrating a method of manufacturing a molding member according to another embodiment of the present disclosure.
FIG. 11 is a schematic cross-sectional view illustrating a display apparatus according to an embodiment of the present disclosure.
FIG. 12 is a schematic cross-sectional view illustrating a display apparatus according to another embodiment of the present disclosure.
FIG. 13A is an enlarged cross-sectional view of an example in which a portion of FIG. 12 is enlarged.
FIG. 13B is a cross-sectional view of another example in which a portion of FIG. 12 is enlarged.
FIG. 14 is a schematic cross-sectional view illustrating a display apparatus according to another embodiment of the present disclosure.

### [Best Mode]

Hereinafter, embodiments will be described in detail with reference to the accompanying drawings. The following embodiments are provided by way of example so as to fully convey the spirit of the present disclosure to those skilled in the art to which the present disclosure pertains. Accordingly, the present disclosure is not limited to the embodiments disclosed herein and can also be implemented in different forms. In the drawings, widths, lengths, thicknesses, and the like of elements can be exaggerated for clarity and descriptive purposes. When an element or layer is referred to as being "disposed above" or "disposed on" another element or layer, it can be directly "disposed above" or "disposed on" the other element or layer or intervening elements or layers can be present. Throughout the specification, like reference numerals denote like elements having the same or similar functions.

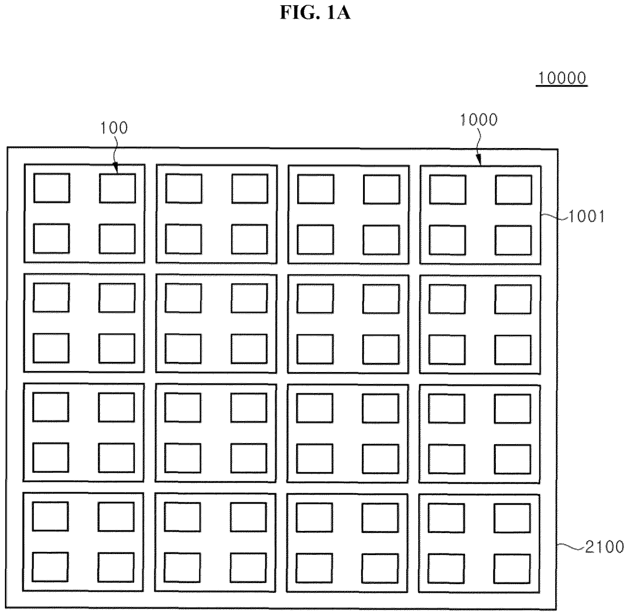

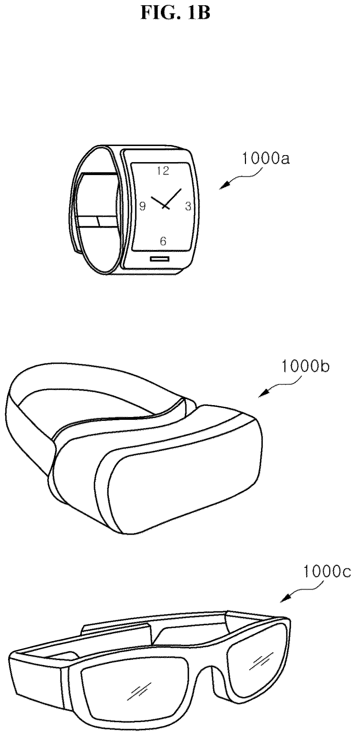

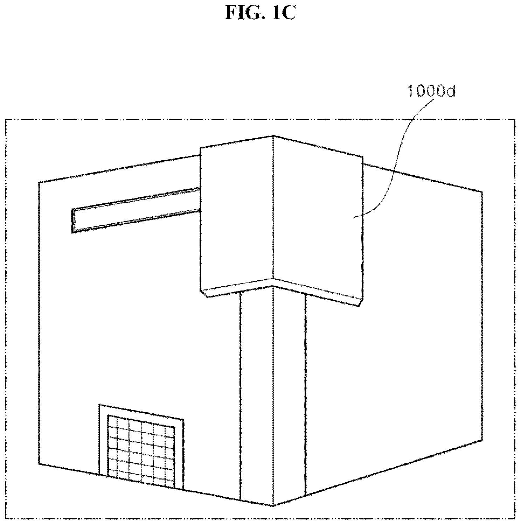

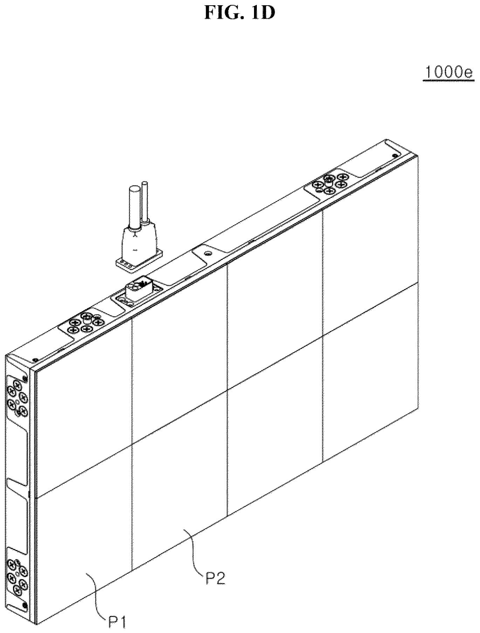

FIG. 1A is a schematic plan view illustrating a display apparatus according to an exemplary embodiment, and FIGs. 1B, 1C, and 1D are schematic perspective views illustrating various display apparatuses 1000a, 1000b, 1000c, 1000d, and 1000e according to an exemplary embodiment.

Referring to FIG. 1A, a display apparatus 10000 may include a panel substrate 2100 and a plurality of pixel modules 1000.

The display apparatus 10000 is not particularly limited, but may include a smart watch 1000a, a wearable display apparatus 1000b such as a VR headset or glasses, an AR display apparatus 1000c such as augmented reality glasses, or an indoor or outdoor display apparatus 1000d or 1000e such as a micro LED TV or signage. The panel substrate 2100 and the plurality of pixel modules 1000 may be disposed in the display apparatus.

The panel substrate 2100 may be formed of a material such as polyimide (PI), FR4, or glass, and may include a circuit for driving a passive matrix or an active matrix. In an embodiment, the panel substrate 2100 may include interconnections and resistors therein. In another embodiment, the panel substrate 2100 may include interconnections, transistors, and capacitors. In addition, the panel substrate 2100 may have pads electrically connected to circuits on its upper surface.

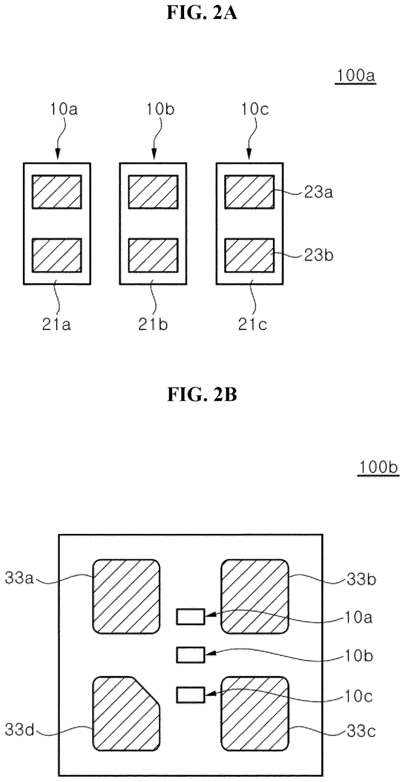

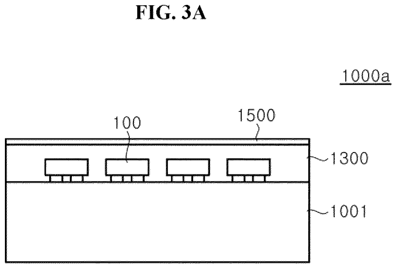

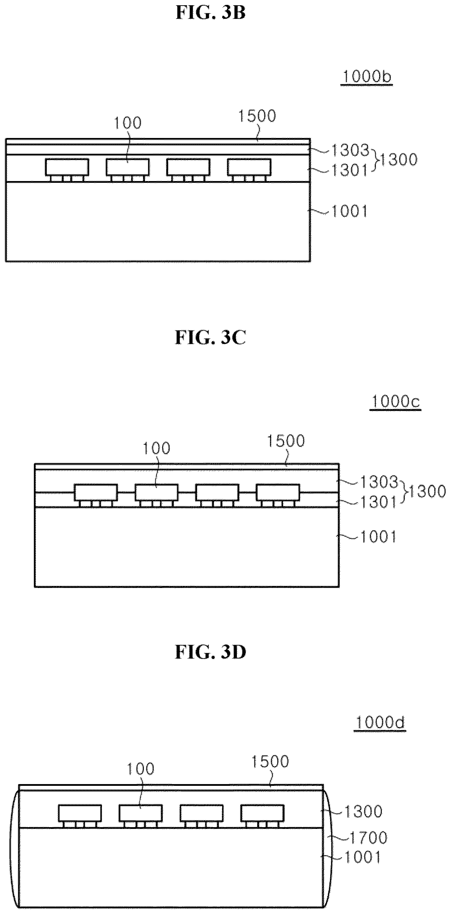

A plurality of light emitting modules 1000 may be arranged on the panel substrate 2100. The light emitting modules 1000 may be disposed with an interval from one another, or may be disposed to be in close contact with one another. The interval between the light emitting modules 1000 may be set in consideration of an interval between unit pixels 100 which will be described later. For example, the interval between two adjacent unit pixels 100 disposed in adjacent light emitting modules 1000, respectively, may be substantially same as an interval between unit pixels 100 in one light emitting module 1000. However, the present disclosure is not necessarily limited thereto. The unit pixel 100 will be described in detail with reference to FIGs. 2A through 2D, and the light emitting module 1000 will be described in detail with reference to FIGs. 3A and 3D.

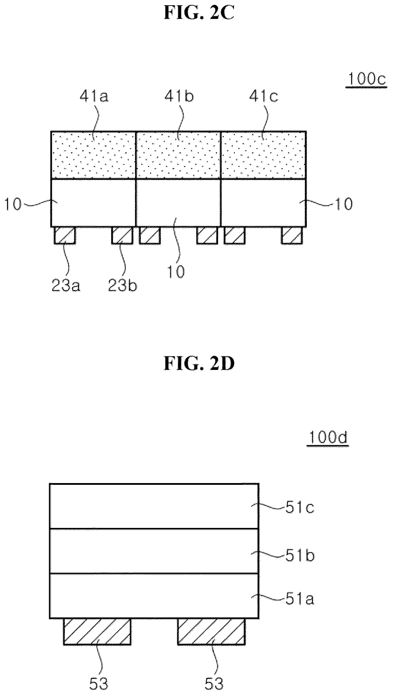

FIG. 2A is a schematic plan view illustrating a unit pixel 100a according to an exemplary embodiment, FIG. 2B is a schematic plan view illustrating a unit pixel 100b according to an exemplary embodiment, FIG. 2C is a schematic cross-sectional view illustrating a unit pixel 100c according to an exemplary embodiment, and FIG. 2D is a schematic cross-sectional view illustrating a unit pixel 100d according to an exemplary embodiment.

Referring to FIG. 2A, the unit pixel 100a includes a red light emitting diode chip 10a, a green light emitting diode chip 10b, and a blue light emitting diode chip 10c. Each of the light emitting diode chips may include light emitting structures 21a, 21b, and 21c and electrode pads 23a, 23b, and 23c disposed on the light emitting structure.

Each of the light emitting structures 21a, 21b, and 21c of the light emitting diode chips 10a, 10b, and 10c includes a first conductivity type semiconductor layer, an active layer, and a second conductivity type semiconductor layer. Although not shown in the drawings, the light emitting diode chips 10a, 10b, and 10c may further include an ohmic contact layer in ohmic contact with the second conductivity type semiconductor layer, first and second contact pads, and an insulation layer. The electrode pads 23a and 23b may be connected to the first and second contact pads to be electrically connected to the first and second conductivity type semiconductor layers.

In an embodiment, in a case of the red light emitting diode chip 10a, the semiconductor layers may include aluminum gallium arsenide (AlGaAs), gallium arsenide phosphide (GaAsP), aluminum gallium indium phosphide (AlGaInP), or gallium phosphide (GaP).

In a case of the green light emitting diode chip 10b, the semiconductor layers may include indium gallium nitride (InGaN), gallium nitride (GaN), gallium phosphide (GaP), aluminum gallium indium phosphide (AlGaInP), or aluminum gallium phosphide (AlGaP).

In an embodiment, in a case of the blue light emitting diode chip 10c, the semiconductor layer may include gallium nitride (GaN), indium gallium nitride (InGaN), or zinc selenide (ZnSe).

The first conductivity type and the second conductivity type have opposite polarities, when the first conductivity type is an n-type, the second conductivity type is a p-type, and when the first conductivity type is the p-type, the second conductivity type becomes the n-type.

The first conductivity type semiconductor layer, the active layer, and the second conductivity type semiconductor layer may be grown on a growth substrate in a chamber using a known method such as metal organic chemical vapor deposition (MOCVD). The active layer of each of the light emitting diode chips may include a single quantum well structure or a multi-quantum well structure, and a composition ratio of semiconductors is adjusted to emit a desired wavelength.

The light emitting diode chips 10a, 10b, and 10c may be directly mounted on a circuit board 1001 using the electrode pads 23a and 23b.

Referring to FIG. 2B, the unit pixel 100b may be provided in a module type including the light emitting diode chips 10a, 10b, and 10c described above. The light emitting diode chips 10a, 10b, and 10c may be individually electrically connected to individual pads 33a, 33b, and 33c, and commonly electrically connected to a common pad 33d. For example, anodes of the light emitting diode chips 10a, 10b, and 10c may be electrically connected to the individual pads 33a, 33b, and 33c, and cathodes may be connected to the common pad 33d, or vice versa. The unit pixel 100b may be mounted on a linking substrate 1001a using the pads 33a, 33b, 33c, and 33d.

Referring to FIG. 2C, the unit pixel 100c may include light emitting diode chips 10 and wavelength conversion material layers 41a, 41b, and 41c. Each of the light emitting diode chips 10 may have the electrode pads 23a and 23b, and may be mounted on the linking substrate using the electrode pads 23a and 23b.

The light emitting diode chips 10 may emit ultraviolet or blue light, and the wavelength conversion material layers 41a, 41b, and 41c may convert light emitted from the light emitting diode chips 10 into red, green, and blue, respectively. When the light emitting diode chip 10 emits blue light, the wavelength conversion material layer 41c may be omitted.

The wavelength conversion material layer 41c may include phosphors or quantum dots. For red, green, and blue phosphors, known phosphors may be used. The quantum dots may include group II-VI, group III-V, group IV-VI, group I-III-VI, and group II-IV-VI semiconductors as semiconductor materials, alloys or mixtures thereof. In particular, they may include CdSe, InAs, ZnSe, InP, GaP, CD, ZnS, HgTe, PbSe, and a ternary system such as CuInS₂, and may also include a doped material.

The quantum dots may be round or rod-shaped, the round-type quantum dots may have a size of about 2 nm to 20 nm, and the rod-shaped quantum dots may have a size of about 9×12 nm.

Referring to FIG. 2D, the unit pixel 100d has a structure in which a first semiconductor stack 51a, a second semiconductor stack 51b, and a third semiconductor stack 51c are vertically stacked. The first through third semiconductor stacks 51a, 51b, and 51c may be adhered to one another through an adhesive. Each of the first through third semiconductor stacks 51a, 51b, and 51c includes a first conductivity type semiconductor layer, an active layer, and a second conductivity type semiconductor layer.

In an embodiment, the first semiconductor stack 51a emits red light, the second semiconductor stack 51b emits green light, and the third semiconductor stack 51c emits blue light. In another embodiment, the second semiconductor stack 51b may emit blue light, and the third semiconductor stack 51c may emit green light.

The unit pixel 100d also includes electrode pads 53. Although two electrode pads 53 are shown in the drawing, in this embodiment, at least four electrode pads 53 may be disposed. One electrode pad may be commonly electrically connected to the first through third semiconductor stacks 51a, 51c, and 51d, and three electrode pads 53 may be individually electrically connected to the first through third semiconductor stacks 51a, 51b, and 51c. For example, one electrode pad may be commonly electrically connected to cathodes of the first through third semiconductor stacks 51a, 51c, and 51d, and three electrode pads 53 may be individually electrically connected to anodes of the first through third semiconductor stacks 51a, 51b, and 51c, or vice versa.

Although various structures of the unit pixel 100 have been described above, the present disclosure is not limited thereto. The unit pixel 100 may be provided in various structures in addition to the structures described above, and any structure may be included in the present disclosure as long as it emits three primary colors of red, green, and blue.

The unit pixel 100 is disposed on the circuit board 1001 and mounted on the panel substrate 2100. A plurality of unit pixels 100 is disposed on the circuit board 1001 and the light emitting module 1000 is formed. By forming a pixel module 1000 and disposing the pixel module 1000 on the panel substrate 2100, the light emitting module 1000 may be repaired or replaced after checking a defective pixel in each light emitting module 1000. Since the light emitting module instead of an entire display apparatus needs to be replaced or repaired, it is not necessary to repair or discard the entire display apparatus, and thus, cost loss due to defects may be reduced.

Although the light emitting module 1000 is described as being mounted on the panel substrate 2100 in this embodiment, the light emitting modules 1000 are mounted in a cabinet, and a plurality of cabinets in which the light emitting modules 1000 is mounted may be mounted on the panel substrate 2100.

FIG. 3A is a schematic cross-sectional view illustrating a light emitting module 1000a according to an embodiment of the present disclosure.

Referring to FIG. 3A, the light emitting module 1000a according to an embodiment may include a circuit board 1001, a plurality of unit pixels 100, a molding member 1300, and an anti-glare layer 1500.

The circuit board 1001 may have a circuit for electrically connecting a panel substrate 2100 and the plurality of unit pixels 100. A circuit in the circuit board 1001 may be formed in a multilayer structure. In addition, the circuit board 1001 may include a passive circuit for driving the plurality of unit pixels 100 in a passive matrix driving manner or an active circuit for driving the plurality of unit pixels 100 in an active matrix driving manner. The circuit board 1001 may have pads exposed on a surface thereof, and the plurality of unit pixels 100 may be bonded to the pads of the circuit board 1001 through a bonding material. In addition, the circuit board 1001 may include a solder resist on the surface thereof, and the solder resist may be black. For example, a black photo solder resistor (PSR) may be provided on the surface of the circuit board 1001. By using the black solder resist, a brightness difference between regions in the light emitting module 1000a may be reduced, and further, a brightness difference between the plurality of light emitting modules 1000a may be reduced.

The plurality of unit pixels 100 is arranged on the circuit board 1001. The plurality of unit pixels 100 may emit red light, green light, and blue light, for example. Since specific examples of the unit pixel 100 have been described with reference to FIGs. 2A through 2D, a detailed description thereof will be omitted.

The plurality of unit pixels 100 may be arranged on the circuit board 1001 in a matrix form. The plurality of unit pixels 100 may be arranged on the circuit board in a 2x2 matrix as shown in FIG. 1A, without being limited thereto, and may be arranged in various matrices, such as 3x3, 4x4, and 5x5 (n×m, n = 1,2,3,4, .. , m=1,2,3,4, •• ).

The molding member 1300 covers the unit pixels 100. An upper surface of the molding member 1300 may be higher than upper surfaces of the unit pixels 100. The upper surface of the molding member 1300 may have a substantially uniform height and, in an embodiment, may be flat. A height from an upper surface of the circuit board 1001 to the upper surface of the molding member 1300 may be substantially uniform over an entire region of the circuit board 1001. For example, upper surface heights (or thicknesses) of the molding member 1300 measured at four corners of the circuit board 1001 may be within a range of ±10%, ±5%, or ±3% of an average value thereof, and furthermore, may be within a range of ±2% of an average value thereof, furthermore, within a range of ±1% of an average value thereof. The average value of the molding member 1300 measured at the four corners of the circuit board 1001 may be about 200um or more and about 450um or less, and specifically, may be about 230um or more and 420um or less. The molding member 1300 may be thicker than the unit pixels 100, and may be formed to have a thickness greater than 1.2 times of a height of the unit pixels 100. The height of the molding member 1300 may be within a range of 100um or more and 350um or less, specifically, may be 120um or more and 300um or less, and may be as high as or higher than the height of the unit pixel 100 from a height of the upper surface of the unit pixel 100. The thickness of the molding member 1300 disposed over the unit pixels 100 may be less than five times of the height of the unit pixels 100. Since the molding member 1300 is disposed at a uniform height, substantially uniform brightness may be exhibited in an entire region in the light emitting module 1000. In addition, when used in a display apparatus, an image generated by the light emitting module 1000 may exhibit a uniform image quality. In addition, by employing the light emitting modules 1000 to implement the display apparatus, the brightness difference between the light emitting modules 1000 may be alleviated and a difference in image quality may be reduced.

The molding member 1300 may be formed using an ultraviolet curable resin. By using the ultraviolet curable resin, a hardness of the molding member 1300 may be increased compared to a heat curable resin. The molding member 1300 may include, for example, acryl-based, silicone-based, or urethane-based resin. For example, the molding member 1300 may include urethane acrylate. In addition, the molding member 1300 may be transparent, or may be opaque by including a light absorber or dye. For example, the molding member 1300 may be black or gray by including carbon black. Meanwhile, the molding member 1300 may include a diffuser, and may further include a matting agent. The diffuser and the matting agent may be, for example, silica. The matting agent may have a size smaller than that of the diffuser, and may be disposed on the surface of the molding member 1300 in a larger number than that of the diffuser. Brightness uniformity in the entire region in the light emitting module 1000 may be improved by using the diffuser. In addition, by using the diffuser and the matting agent, a specular reflection component may be reduced and a diffuse reflection component may be increased, and image sharpness of reflected light may be reduced.

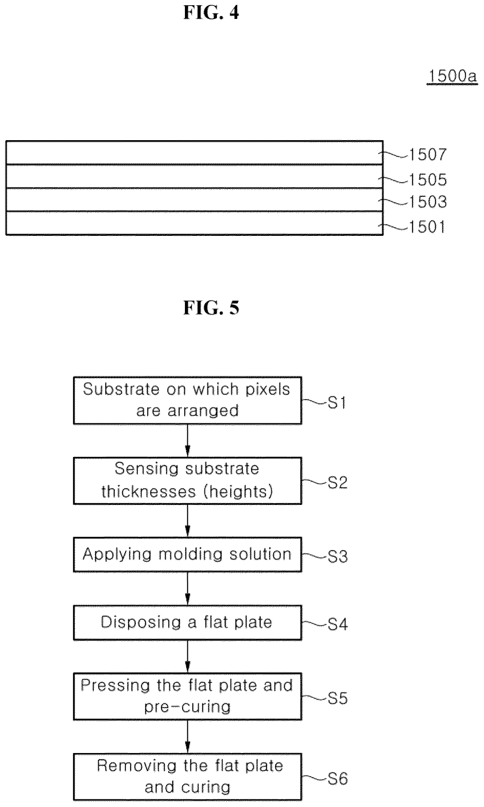

The anti-glare layer 1500 covers the molding member 1300. The anti-glare layer 1500 may prevent glaring by mixing fine particles such as silica, melamine, and acryl with cured resin to scatter light. The anti-glare layer 1500 may include fine particles such as silica, melamine, acryl, and the like together with polymers such as acrylic, silicone, urethane, and the like. An anti-glare effect may be adjusted by adjusting a thickness of the anti-glare layer 1500 and densities and sizes of the particles. The anti-glare layer 1500 may have a thickness of 20um to 95um. The anti-glare layer 1500 may be a coating layer coated through spraying, or may be a film attached using an anti-glare film. The anti-glare film is shown in FIG. 4, for example.

As shown in FIG. 4, an anti-glare film 1500a may include a base 1501, an anti-glare hard coating layer 1503, a low-reflection coating layer 1505, and an adhesive 1507. The base 1501 may be, for example, a PET or polyimide film. In an embodiment, the base 1501 may be black. The anti-glare hard coating layer 1503 may include fine particles such as silica, melamine, acryl, and the like together with polymers such as acrylic, silicone, urethane, and the like.

The low-reflection coating layer 1505 improves a luminance of the light emitting module by preventing reflection of light emitted from the unit pixels 100. In an embodiment, the low-reflection coating layer 1505 may be coated on the anti-glare hard coating layer 1503. The low-reflection coating layer 1505 may be an anti-reflector (AR) coating film obtained by applying a polymer material such as polyethylene terephthalate (PET) or tri-acetyl cellulose (TAC) by a wet coating method. In another embodiment, the anti-reflection layer 1505 may be formed by alternately stacking inorganic layers having different refractive indices from one another. For example, at least two of oxide layers such as indium tin oxide (ITO), SiO₂, SiON, Si₃N₄, TiO₂, and Ta₂O₅ may be stacked on the anti-glare hard coating layer 1503 to form the low-reflection coating layer 1505. The low-reflection coating layer 1505 may use interference of light generated at an interface between thin films by stacking two or more thin films having different refractive indices from one another. Wavelengths of light reflected from the interface of each of the thin films may be set to cause destructive interference, and thus, a reflectance of the low-reflection coating layer 1505 may be reduced and transmittance may be increased, thereby increasing the luminance of the display apparatus.

The adhesive 1507 is used to attach the anti-glare film 1500a to the molding member 1300. The adhesive 1507 may be, for example, a pressure sensitive adhesive (PSA). A thickness of the adhesive 1507 may be within a range of 10um to 40um, and the adhesive 1507 may be formed smaller than a thickness of the anti-glare hard coating layer 1503. For example, when the thickness of the anti-glare hard coating layer 1503 is 30um to 40um, the thickness of the adhesive 1507 may be 10um to 25um, when the thickness of the anti-glare hard coating layer 1503 is 45um to 55 um, the thickness of the adhesive 1507 may be 18um to 30um, and when the thickness of the anti-glare hard coating layer 1507 is 65um to 80um, the thickness of the adhesive 1507 may be 25um to 40um. By forming the adhesive 1507 with a thickness smaller than that of the anti-glare hard coating layer 1503, the effect of preventing the glare phenomenon can be increased. In addition, generally uniform brightness or uniform image quality can be displayed throughout the entire area within the light-emitting module, and differences in brightness between light-emitting modules can be reduced.

In this embodiment, it is described that the anti-glare layer 1500 is formed using resin, but the anti-glare layer 1500 may be formed using glass. An anti-fingerprint layer, an anti-fouling layer, an anti-glare layer, and the like may be coated on a surface of a glass, and the glass may be attached to the molding member 1300. A thickness of the glass may be about 150um to 350um.

FIG. 3B is a schematic cross-sectional view illustrating a light emitting module 1000b according to another embodiment of the present disclosure.

Referring to FIG. 3B, the light emitting module 1000b according to this embodiment is substantially similar to the light emitting module 1000a described with reference to FIG. 3A, but a molding member 1300 of this embodiment differs from the molding member 1300 of FIG. 3A in that it includes a first molding member 1301 and a second molding member 1303.

Since the first molding member 1301 is similar to the molding member 1300 described with reference to FIG. 3A, a detailed description thereof will be omitted. The second molding member 1303 is formed on the first molding member 1301. In an embodiment, the second molding member 1303 may be formed using an ultraviolet curable resin, and may be black by including a dye such as carbon black. According to this embodiment, unlike an anti-glare film, when the anti-glare layer 1500 is formed using a spray coating layer, a brightness uniformity of the light emitting module 1000b may be increased by adding the second molding member 1303 of black color. Furthermore, the second molding member 1303 may include a diffuser and/or a matting agent, but the present disclosure is not limited thereto, and the second molding member 1303 may not include a diffuser or a matting agent.

In another embodiment, a hardness enhancement layer may be disposed instead of or in addition to the second molding member 1303. The hardness enhancement layer may be disposed on the first molding member 1301 by using an optical adhesive material. The hardness enhancement layer may include glass or plastic, and the plastic may include, for example, polymethyl methacrylate (PMMA), polycarbonate, and the like.

FIG. 3C is a schematic cross-sectional view illustrating a light emitting module 1000c according to another embodiment of the present disclosure.

Referring to FIG. 3C, the light emitting module 1000c according to this embodiment is substantially similar to the light emitting module 1000b described with reference to FIG. 3B, except that the first molding member 1301 is formed to have a height smaller than that of the unit pixel 100. In addition, in this embodiment, the anti-glare layer 1500 may be a coating layer coated by spraying, or may be an anti-glare film as shown in FIG. 4.

In this embodiment, the first molding member 1301 may include, for example, acryl-based, silicone-based, or urethane-based resin. For example, the molding member 1301 may include urethane acrylate. In addition, the molding member 1301 may be transparent, or may be opaque by including a light absorber or dye. For example, the molding member 1301 may be black or gray by including carbon black. Meanwhile, the molding member 1301 may include a diffuser, and may further include a matting agent. By using the diffuser, the brightness uniformity may be improved over an entire region in the light emitting module 1000c. The first molding member 1301 may be formed using inkjet. By forming the first molding member 1301 using the inkjet, the first molding member 1301 having a substantially uniform thickness may be formed on the circuit board 1001. For example, thicknesses of the first molding member 1301 measured at the four corners of the circuit board 1001 may be within a range of ±10% of an average value thereof.

The second molding member 1303 covers the first molding member 1301 and the unit pixels 100. The second molding member 1303 may be transparent or opaque similar to the first molding member 1301. The second molding member 1303 may include a diffuser, but the present disclosure is not limited thereto, and the second molding member 1303 may not include a diffuser. The second molding member 1303 may also include a matting agent, without being limited thereto.

A method of forming the second molding member 1303 is not particularly limited, and may be formed through various methods. The second molding member 1303 may be formed by pressing a plate similarly to the molding member 1300 of FIG. 3A, which will be described in detail later with reference to FIG. 5.

FIG. 3D is a schematic cross-sectional view illustrating a light emitting module 1000d according to another embodiment of the present disclosure.

Referring to FIG. 3D, the light emitting module 1000d according to this embodiment is substantially similar to the light emitting module 1000a described with reference to FIG. 3A, except that a side seal 1700 is further included. The side seal 1700 may cover at least portions of side surfaces of the light emitting module 1000d. For example, the side seal 1700 may cover entire side surfaces of the light emitting module 1000d. As another example, the side seal 1700 may partially cover an upper region among the side surfaces of the light emitting module 1000d. As another example, the side seal 1700 may partially cover the side surfaces of the light emitting module 1000d, and may partially cover at least one corner region among four corner regions. The side seal 1700 may be formed of a same or similar material as that of the molding member 1300. For example, the side seal 1700 may include, for example, acryl-based, silicone-based, or urethane-based resin. For example, the side seal 1700 may include urethane acrylate. In addition, the side seal 1700 may be transparent, or may be opaque by including a light absorber or dye. For example, the side seals 1700 may be black or gray, including carbon black. The side seal 1700 may be formed in various ways such as a pen, roller, or printing method. The side seal 1700 may be used to prevent a white line, a dark line, or a bright line from being observed between the light emitting modules 1000d when a display is implemented by arranging the light emitting modules 1000d, or may be used to dispose the light emitting modules 1000d in close contact with one another.

In this embodiment, it is described that the side seal 1700 is formed on a side surface of the light emitting module 1000a of FIG. 3A, but the side seal 1700 may be formed on a side surface of the light emitting module 1000b of FIG. 3B or the light emitting module 1000c of FIG. 3C.

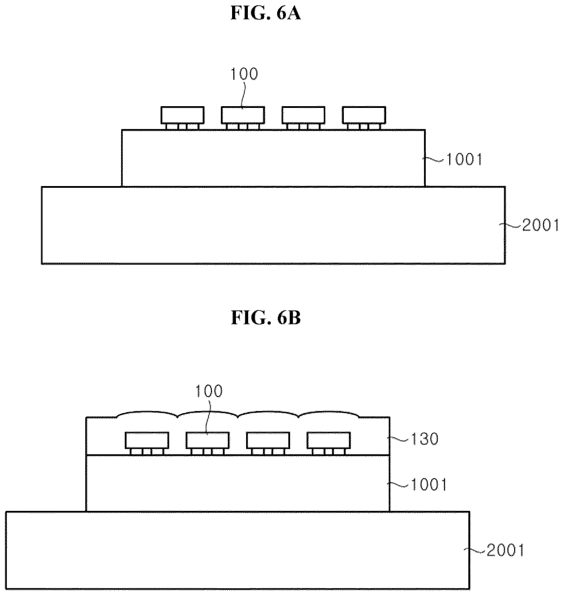

FIG. 5 is a schematic flowchart illustrating a method of manufacturing a light emitting module according to an embodiment of the present disclosure, and FIGs. 6A through 6E are schematic cross-sectional views illustrating a method of manufacturing the light emitting module according to an embodiment of the present disclosure.

Referring to FIGs. 5 and 6A, a circuit board 1001 on which unit pixels 100 are arranged is prepared (S1). The unit pixel 100 may be mounted on the circuit board 1001. A plurality of unit pixels 100 may be arranged on the circuit board 1001. The unit pixels 100 may be entirely transferred onto the circuit board 1001 at one time, or may be sequentially arranged on the circuit board 1001 one by one or in groups.

The circuit board 1001 on which the unit pixels 100 are arranged may be loaded into a molding member forming apparatus, cleaned, and then disposed on, for example, a chuck or a jig 2001. The circuit board 1001 may be held by vacuum adsorption on the jig 2001 or using clamping, and in this process, warpage or distortion of the circuit board 1001 may be alleviated.

After the circuit board 1001 is disposed on the jig 2001, a thickness (or height) of the circuit board 1001 is sensed (S2). A height of an upper surface of the circuit board 1001 with respect to an upper surface of the jig 2001 may be measured using a sensor. For example, with respect to the height of the circuit board 1001 at a center of the jig 2001, heights at various positions of the circuit board 1001 may be measured, and through this, a height profile of the upper surface of the circuit board 1001 may be checked.

Referring to FIGs. 5 and 6B, after the measurement of the height of the circuit board 1001 is completed, a molding solution 130 may be sprayed onto the circuit board 1001 (S3). The molding solution 130 may include an ultraviolet curable resin, and may include a diffuser. The molding solution 130 may be applied, coated, or jetted on the circuit board 1001, but the present disclosure is not limited thereto.

When a molding member 1300 is formed by applying the molding solution, it is difficult to apply the molding solution 130 with a uniform thickness on the circuit board 1001. The present disclosure discloses a method of forming the molding member 1300 with a uniform thickness along the profile of the circuit board 1001 by applying the molding solution 130 and using a plate 2003.

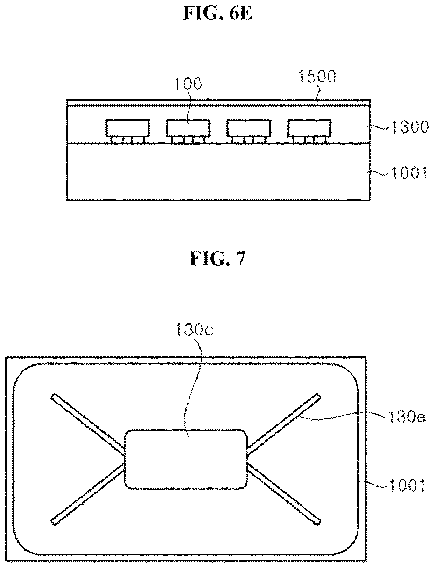

When the molding solution is applied to an entire surface of the circuit board 1001, the molding solution accumulates on an edge of the circuit board 1001, so that the molding member 1300 may be thickly formed on the edge of the circuit board 1001. To prevent this, the molding solution 130 may be applied to a portion of the circuit board 1001 rather than to the entire surface of the circuit board 1001 in this embodiment. In particular, a greater amount of the molding solution 130 may be applied to a central portion compared to other portions of the circuit board 1001, so that the central portion may be applied in an upwardly convex shape. A shape of the molding solution 130 applied on the circuit board 1001 is schematically shown in FIG. 7. Referring to FIG. 7, the molding solution 130 may be applied in a large amount to the central portion of the circuit board 1001, and may be applied in a branched shape toward corners of the circuit board 1001 from the central portion. The molding solution 130 may include a first portion 130c applied to the central portion of the circuit board 1001 and at least four branch portions 130e extending from the first portion to the corners of the circuit board 1001. An amount of molding solution applied to the first portion 130c applied to the central portion of the circuit board 1001 may be greater than that applied to the branch portions 130e. In addition, amounts of molding solution applied to the branch portions 130e may be substantially same as one another. Meanwhile, a terminal of each of the branch portions 130e is spaced apart from the corner of the circuit board 1001. When the terminals of the branch portions 130e are too close to the corners, the molding solution may accumulate on the corner side in a subsequent process, and a thickness of the molding member 1300 at the corner of the circuit board 1001 may become large. The molding solution may be sequentially applied to the branch portions 130e first, and the molding solution may be applied last to the first portion 130c. A relatively large amount of molding solution is applied to the first portion 130c, but a time for the molding solution applied to the first portion 130c to flow to a surrounding thereof may be shortened, by applying the molding solution to the first portion 130c last.

In this embodiment, the application of the molding solution differently depending on positions on the circuit board 1001 is described, but a pattern of applying the molding solution to form the molding member 1300 may vary, and it is not limited to the present disclosure. For example, the molding solution may be applied in various shapes such as a zigzag pattern.

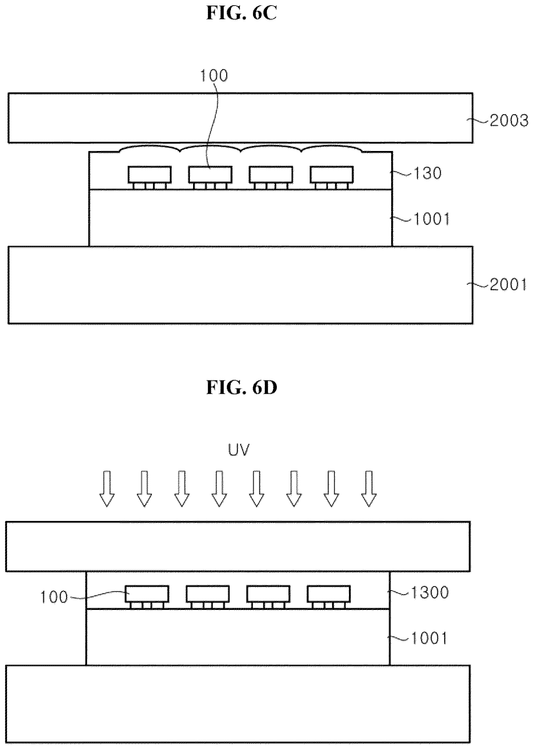

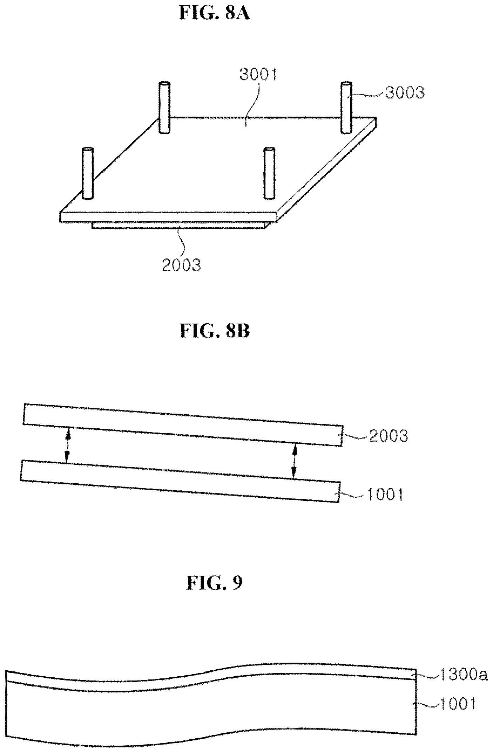

Referring to FIGs. 5 and 6C, a flat plate (plate 2003) is disposed on the circuit board 1001 applied with the molding solution 130 (S4). The flat plate 2003 is disposed such that its lower surface is parallel to the upper surface of the circuit board 1001. A relative arrangement of the flat plate 2003 and the circuit board 1001 may be adjusted by adjusting an inclination of the lower surface of the flat plate 2003 along the height profile of the circuit board 1001. FIG. 8A and FIG. 8B schematically illustrate an apparatus and a method for adjusting the inclination of the flat plate 2003. As shown in FIG. 8A, the flat plate 2003 may be vacuum adsorbed in a holder 3001. An inclination of the holder 3001 may be adjusted by four axes 3003, and the inclination of the flat plate 2003 may be adjusted by adjusting the inclination of the holder 3001. As shown in FIG. 8B, when the upper surface of the circuit board 1001 is inclined, the inclination of the flat plate 2003 is adjusted such that a lower surface of the flat plate 2003 is generally parallel to the upper surface of the circuit board 1001 using the four axes 3003.

The plate 2003 is not particularly limited, and may be, for example, a glass substrate, a quartz substrate, or an acrylic substrate.

A shape of a molding layer 130 may be modified by the plate 2003. The plate 2003 may go down to a set height, and may modify the molding layer 130 to a set thickness. As pressure is applied to the molding layer 130 using the plate 2003, the molding layer 130 disposed in the central portion spreads to a peripheral region of the circuit board 1001.

Referring to FIGs. 5 and 6D, after the inclination of the flat plate 2003 is adjusted, the flat plate 2003 may be pressed against the circuit board 1001 to form the molding member 1300. While pressing the flat plate 1003, for example, UV may be irradiated to pre-cure the molding member 1300.

The lower surface of the flat plate 2003 may be a flat surface, and accordingly, the upper surface of the molding member 1300 may be modified to be flat like the lower surface of the flat plate 2003. In another embodiment, the flat plate 2003 may have nano-patterned or micro-patterned irregularities on its lower surface, and the molding member 1300 may be modified to have irregularities along a shape of the lower surface of the flat plate 2003.

The pre-cured molding member 1300 may be unloaded from the molding member forming apparatus with the flat plate 1003 disposed thereon, and thereafter, the flat plate is removed from the molding member 1300 and the molding member 1300 may be cured (S6).

Referring to FIG. 6E, the anti-glare layer 1500 may be formed on the molding member 1300. The anti-glare layer 1500 may be formed using a spray or by attaching an anti-glare film. Accordingly, the light emitting module 1000a described with reference to FIG. 3A may be formed.

According to this embodiment, the molding member 1300 having the uniform thickness as a whole is formed on the circuit board 1001 by adjusting the inclination of the flat plate 2003 according to the upper surface profile of the circuit board 1001. Accordingly, uniform brightness may be achieved over an entire region of the light emitting module 1000a.

FIG. 9 is a schematic cross-sectional view illustrating a method of manufacturing a molding member according to another embodiment of the present disclosure.

Referring to FIG. 9, the circuit board 1001 may be in a distorted state. That is, even when the thickness of the circuit board 1001 is uniform, the height of the upper surface may vary depending on a position thereof. Moreover, the distortion of the circuit board 1001 is not completely straightened even when vacuum adsorbed using a jig or the like or held using clamping. When the molding member 1300 is formed using the flat plate 2003 on the circuit board 1001 that is distorted as described above, the molding member 1300 having a nonuniform thickness is formed on the circuit board 1001. To solve this drawback, in this embodiment, a molding member 1300a is formed using inkjet technology. Since the molding member 1300a is formed using the inkjet technique, the molding member 1300a may be formed with a uniform thickness along the upper surface profile of the circuit board 1001. In particular, the molding member 1300a formed using the inkjet may cover the unit pixels 100. When an amount of the molding member applied using the inkjet is small, the molding member 1300a is formed along the upper surface of the unit pixels 100 and a region between the unit pixels 100, and thus, it may be formed in a concave shape between them. As the amount of the molding member increases, a depth of a concave portion decreases, and the molding member 1300a may have a substantially flat upper surface. For example, as a thickness of the molding member 1300a increases, the upper surface of the molding member 1300a may become substantially flat. Thereafter, an anti-glare layer may be formed on the molding member 1300a.

In this embodiment, the molding member 1300a may be transparent or opaque, and includes a diffuser. As the molding member 1300a is formed with the uniform thickness on the circuit board 1001, a brightness uniformity over the entire region of the light emitting module may be improved.

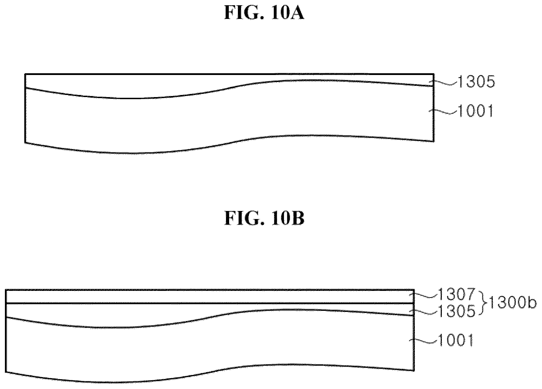

FIG. 10A and FIG. 10B are schematic cross-sectional views illustrating a method of manufacturing a molding member according to another embodiment of the present disclosure.

First, referring to FIG. 10A, a first molding member 1305 is formed on the circuit board 1001. The first molding member 1305 is a transparent molding member. The first molding member 1305 may be formed smaller than a thickness of the unit pixels 1001, and may cover the unit pixels 100. The first molding member 1305 provides a flat upper surface. The first molding member 1305 may provide the flat upper surface regardless of the profile of the upper surface of the circuit board 1001 due to distortion. For example, the first molding member 1305 may be formed to have the flat upper surface by pressing using the flat plate 2003.

Referring to FIG. 10B, a second molding member 1307 is formed on the first molding member 1305. The second molding member 1307 may be transparent or opaque, and includes a diffuser. The second molding member 1307 may be formed on the first molding member 1305 with a uniform thickness. For example, thicknesses of the second molding member measured at the four corners of the circuit board 1001 may be within a range of ±10% of an average value thereof.

Thereafter, an anti-glare layer may be formed on the second molding member 1307. Since the first molding member 1305 has the flat upper surface, the second molding member 1307 may be formed uniformly, and accordingly, the brightness uniformity over the entire region of the light emitting module may be improved.

In the previous embodiments, each of the light emitting modules 1000 has been illustrated and described as including the anti-glare layer 1500. The light emitting modules 1000 may be directly arranged on the panel substrate or arranged in the plurality of cabinets, and the plurality of cabinets may be arranged on the panel substrate. The light emitting modules 1000 may be spaced apart or closely attached to one another, but a white line, a black line, or a bright line may occur between the light emitting modules 1000. Hereinafter, a display apparatus for preventing the occurrence of the white line, black line, or bright line between the light emitting modules 1000 will be described.

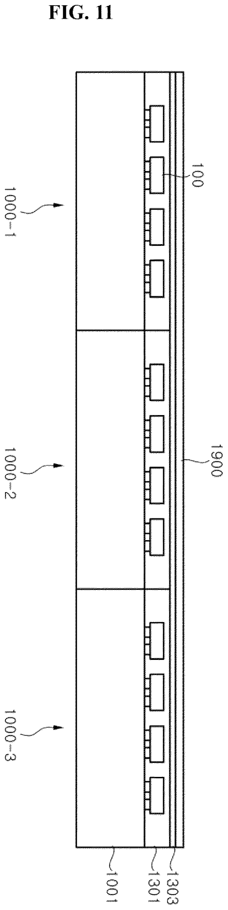

FIG. 11 is a schematic cross-sectional view illustrating a display apparatus according to an embodiment of the present disclosure.

Referring to FIG. 11, light emitting modules 1000-1, 1000-2, and 1000-3 are disposed in close contact with one another. Each of the light emitting modules 1000-1, 1000-2, and 1000-3 may include a circuit board 1001, a plurality of unit pixels 100, and a first molding member 1301. In this embodiment, the light emitting modules 1000-1, 1000-2, and 1000-3 may be any one of the light emitting modules described with reference to FIGs. 3A through 3D, but do not include the anti-glare layer 1500.

Since the circuit board 1001, the unit pixels 100, and the first molding member 1301 have been described with reference to FIGs. 3A through 3D, detailed descriptions thereof are omitted. In this embodiment, the first molding member 1301 includes a diffuser.

The second molding member 1303 covers all of the light emitting modules 1000-1, 1000-2, and 1000-3. The second molding member 1303 may be transparent or opaque. The second molding member 1303 may include a diffuser, and may further include a matting agent.

An anti-glare layer 1900 may be disposed on the second molding member 1303. The anti-glare layer 1900 covers the second molding member 1303. In this embodiment, the anti-glare layer 1900 may be formed using an anti-glare film or glass.

In this embodiment, the second molding member 1303 and the anti-glare layer 1900 cover a plurality of light emitting modules 1000-1, 1000-2, and 1000-3. In particular, the second molding member 1303 covers interfaces between the light emitting modules 1000-1, 1000-2, and 1000-3, and covers regions between the light emitting modules 1000-1, 1000-2, and 1000-3, and thus, it is possible to prevent the white line, black line, or bright line from being observed.

In an embodiment, the second molding member 1303 may be formed on the light emitting modules 1000-1, 1000-2, and 1000-3, and the anti-glare layer 1900 may be formed on the second molding member 1303. The anti-glare layer 1900 may be adhered on the second molding member 1303 using an adhesive. In another embodiment, the second molding member 1303 may be first formed on the anti-glare layer 1900, and the anti-glare layer 1900 and the second molding member 1303 may be attached together on the first molding member 1301.

In this embodiment, three light emitting modules 1000-1, 1000-2, and 1000-3 are shown as being arranged, but the number of light emitting modules is not limited thereto. In addition, in this embodiment, it has been described that the second molding member 1303 and the anti-glare layer 1900 are formed on the plurality of light emitting modules 1000-1, 1000-2, and 1000-3, but the present disclosure is not limited thereto. For example, a plurality of cabinets in which the light emitting modules 1000-1, 1000-2, and 1000-3 are disposed is arranged on a panel substrate or a frame, and the second molding member 1303 and the anti-glare layer 1900 may be formed to cover the light emitting modules 1000-1, 1000-2, and 1000-3 arranged over the plurality of cabinets.

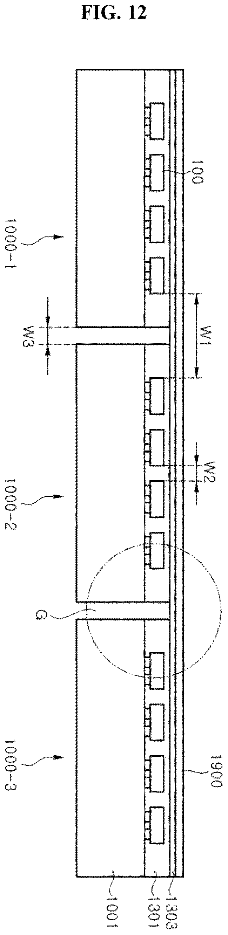

FIG. 12 is a schematic cross-sectional view illustrating a display apparatus according to another embodiment of the present disclosure.

Referring to FIG. 12, the display apparatus according to this embodiment is generally similar to the display apparatus described with reference to FIG. 11, except that the light emitting modules 1000-1, 1000-2, and 1000-3 are spaced apart from one another to have a gap G. A distance W2 between unit pixels 100 disposed on each of the light emitting modules 1000-1, 1000-2, or 1000-3 may be smaller than or equal to a minimum distance W1 between a unit pixel 100 disposed near an edge of one light emitting module 1000-1 and a unit pixel 100 disposed near an edge of an adjacent light emitting module 1000-2. Meanwhile, a width W3 of the gap G between the light emitting modules 1000-1, 1000-2, and 1000-3 may be smaller than the distance W2 between the unit pixels 100 disposed on each of the light emitting modules 1000-1, 1000-2, or 1000-3.

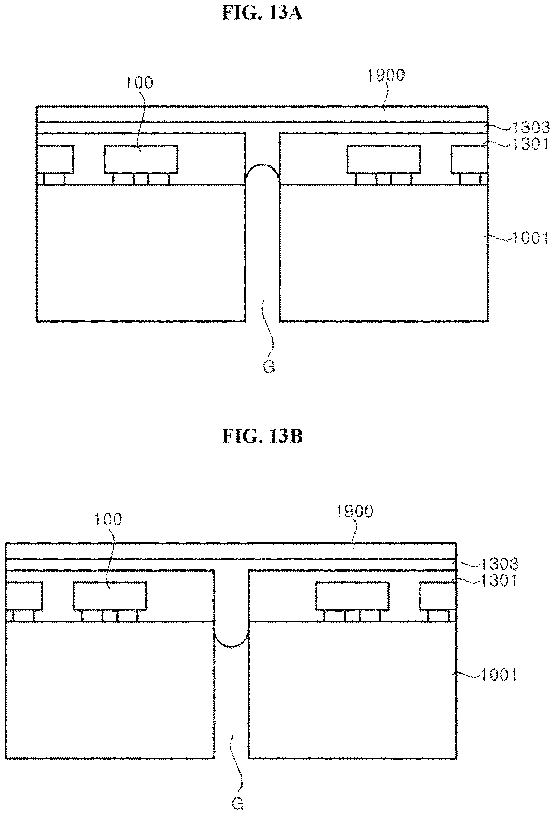

Meanwhile, as shown in FIG. 13A and FIG. 13B, a portion of the second molding member 1303 may be disposed within the gap G between the light emitting modules 1000-1, 1000-2, and 1000-3. For example, when the second molding member 1303 is applied and cured on the light emitting modules 1000-1, 1000-2, and 1000-3, the portion of the second molding member 1303 may be formed within the gap G in a shape as shown in FIG. 13A, and when the second molding member 1303 is formed on the anti-glare layer 1900, and the anti-glare layer 1900 and the second molding member 1303 are attached onto the light emitting modules 1000-1, 1000-2, and 1000-3, a portion of the first molding member 1303 may be formed within the gap G in a shape as shown in FIG. 13B.

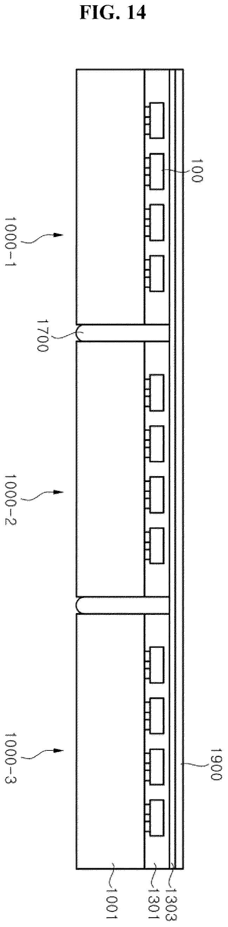

FIG. 14 is a schematic cross-sectional view illustrating a display apparatus according to another embodiment of the present disclosure.

Referring to FIG. 14, the light emitting modules 1000-1, 1000-2, and 1000-3 according to this embodiment of the present disclosure are generally similar to the light emitting modules described with reference to FIG. 12, except that side seals 1700 covering side surfaces thereof are further included. In an embodiment, the side seals 1700 may be first formed on the side surfaces of each of the light emitting modules 1000-1, 1000-2, and 1000-3, and the light emitting modules may be arranged such that the side seals 1700 of the light emitting modules are bonded to one another. The side seal 1700 may be formed of a material different from that of the first molding member 1301, without being limited thereto, and may be formed of a same material as that of the first molding member 1301. In another embodiment, the side seals 1700 may be formed by forming the second molding members 1303 to fill gaps G after the light emitting modules are arranged with the gaps G. The side seals1700 may completely or partially fill the gaps G between the light emitting modules 1000-1, 1000-2, and 1000-3. A width of the side seal 1700 may be 15um to 70um, and specifically may be 20um to 40um. The side seal 1700 may be formed to have a width smaller than or equal to a pitch of the unit pixels adjacent to each other within each of the light emitting modules, and further, may be formed to have a width smaller than or equal to 1/2 of the pitch. In this way, by forming the side seal 1700 with a width smaller than or equal to the pitch of adjacent unit pixels, dark lines or bright lines occurring between light emitting modules can be minimized. Additionally, when used in a display device, the image generated from the light emitting modules can exhibit uniform image quality.

The second molding member 1303 and the anti-glare layer 1900 are formed to cover the side seals 1700 together with the light emitting modules 1000-1, 1000-2, and 1000-3.

Although the side seals 1700 are disposed between the light emitting modules 1000-1, 1000-2, and 1000-3 in this embodiment, the present disclosure is not limited thereto. For example, the light emitting modules 1000-1, 1000-2, and 1000-3 may be disposed in a plurality of cabinets, and the side seals 1700 may be disposed between the plurality of cabinets.

Although some exemplary embodiments have been described herein, it should be understood that these exemplary embodiments are provided for illustration only and are not to be construed in any way as limiting the present disclosure. It should be understood that features or components of one exemplary embodiment can also be applied to other exemplary embodiments without departing from the spirit and scope of the present disclosure.

## Claims

1. A light emitting module, comprising:
a circuit board;
a plurality of unit pixels arranged on the circuit board;
a molding member covering the plurality of unit pixels; and
an anti-glare layer disposed on the molding member,
wherein the molding member includes a diffuser containing molding member.

2. The light emitting module of claim 1,
wherein thicknesses of the diffuser containing molding member measured at four corners of the circuit board are within a range of ±10% of an average value thereof.

3. The light emitting module of claim 1,
wherein the diffuser includes silica.

4. The light emitting module of claim 1, wherein:
the molding member includes a first molding member covering the unit pixels and a second molding member disposed on the first molding member,
the first molding member is a diffuser containing molding member, and
the second molding member is a black molding member.

5. The light emitting module of claim 4,
wherein thicknesses of the first molding member measured at the four corners of the circuit board are within a range of ±10% of an average value thereof.

6. The light emitting module of claim 1, wherein:
the molding member includes a first molding member having a height lower than those of the unit pixels and a second molding member covering the first molding member and the unit pixels, and
the first molding member is a diffuser containing molding member.

7. The light emitting module of claim 1, further comprising:
a side seal covering side surfaces of the circuit board and the molding member.

8. The light emitting module of claim 7,
wherein the side seal is formed of a material different from that of the molding member.

9. The light emitting module of claim 1,
wherein an upper surface profile of the molding member is substantially same as an upper surface profile of the circuit board.

10. The light emitting module of claim 1, wherein:
the molding member includes a first molding member and a second molding member covering the first molding member,
the first molding member is a diffuser-free molding member, and has a flat upper surface, and
the second molding member is a diffuser containing molding member.

11. The light emitting module of claim 10,
wherein thicknesses of the second molding member measured at the four corners of the circuit board are within a range of ±10% of an average value thereof.

12. The light emitting module of claim 1,
wherein the anti-glare layer includes an anti-glare film,
the anti-glare film, including:
a base;
an anti-glare hard coating layer coated on the base;
a low reflection coating layer coated on the anti-glare hard coating layer; and
an adhesive disposed under the base.

13. The light emitting module of claim 12,
wherein at least one of the base and the adhesive includes a black dye.

14. The light emitting module of claim 12,
wherein the adhesive is a pressure sensitive adhesive.

15. A display apparatus, comprising:
a plurality of light emitting modules, each including a circuit board, a plurality of unit pixels arranged on the circuit board, and a first molding member covering the unit pixels;
a second molding member covering the plurality of light emitting modules; and
an anti-glare layer covering the second molding member,
wherein the first molding member and the second molding member include a diffuser containing molding member.

16. The display apparatus of claim 15,
wherein the thicknesses of the diffuser containing molding member of the first molding member measured at four corners of the circuit board of each of the light emitting modules are within a range of ±10% of an average value thereof.

17. The display apparatus of claim 15, wherein:
adjacent light emitting modules are spaced apart with a gap G
a distance W2 between unit pixels in one light emitting module is smaller than or equal to a distance W1 between unit pixels between adjacent light emitting modules, and
a width W3 of the gap G between the light emitting modules is smaller than the distance W2 between unit pixels in one light emitting module.

18. The display apparatus of claim 17,
wherein the second molding member is partially disposed within the gap G between the light emitting modules.

19. The display apparatus of claim 11, wherein:
each of the light emitting modules includes a side seal covering side surfaces thereof, and
the light emitting modules are arranged such that the side seals are in close contact with one another.

20. The display apparatus of claim 15,
wherein the anti-glare layer includes an anti-glare film or anti-glare glass.
